# DEMANDE DE BREVET EUROPEEN

(11) **EP 4 350 265 A1**
(43) Date de publication de la demande: **10.04.2024**
(21) Numéro de dépôt: 23199123.3
(22) Date de dépôt: 22.09.2023
(51) Int. Cl.: F27B 5/04, F27B 17/00, F27D 7/06, F27D 11/12, F27D 99/00, H01L 21/67, H05B 3/00

(54) **FOUR À RECUIT THERMIQUE RAPIDE À ÉTANCHÉITÉ AMÉLIORÉE**

(30) Priorité: 07.10.2022 FR 2210291
(71) Demandeur: Annealsys, 34000 Montpellier (FR)
(72) Inventeur: PERONI, Charles, 34000 MONTPELLIER (FR); DUCRET, René-Pierre, 34000 MONTPELLIER (FR)
(74) Mandataire: Cabinet Beaumont

(57) **Abrégé**

La présente description concerne un four (40) à recuit thermique rapide pour le chauffage d'un objet par un rayonnement électromagnétique, comprenant une première pièce (32), une deuxième pièce (34) au contact direct de la première pièce, et un hublot (26) transparent audit rayonnement, pris en sandwich entre la première pièce et la deuxième pièce, un premier joint (80) entre le hublot et la première pièce, un deuxième joint (82) entre le hublot et la deuxième pièce, un troisième joint (84) entre la première pièce et la deuxième pièce, le premier joint (80) étant un joint métallique, le deuxième joint (82) étant un joint souple, et le troisième joint (84) étant un joint souple.

## Description

La présente demande de brevet revendique la priorité de la demande de brevet français FR22/10291 qui sera considérée comme faisant partie intégrante de la présente description.

### Domaine technique

La présente description concerne de façon générale les fours à recuit thermique rapide, notamment les fours à recuit thermique comprenant des lampes à haute intensité séparées d'une chambre de traitement par un hublot transparent.

### Technique antérieure

Un four à recuit thermique rapide est un four permettant de porter un objet, notamment un substrat de silicium, à haute température, par exemple jusqu'à 1200 °C ou plus, dans un temps très court, en général quelques secondes.

De telles montées en température sont obtenues par des lampes à haute intensité ou par chauffage laser. L'objet à traiter est disposé dans une chambre de traitement sous vide et est exposé au rayonnement émis par les lampes à haute intensité ou au rayonnement laser au travers d'un hublot transparent au rayonnement, notamment un hublot en quartz. Le hublot peut être maintenu entre deux pièces du four délimitant la chambre de traitement par l'intermédiaire de joints souples, par exemple des joints en élastomère, un premier joint entre le hublot et la première pièce et un deuxième joint entre le hublot et la deuxième pièce. Les joints doivent permettre d'assurer l'étanchéité à l'air de la liaison entre le hublot et les deux pièces du four.

Toutefois, pour certaines applications, un vide très poussé, appelé ultravide, par exemple à une pression inférieure à 10⁻⁵ Pa, doit être maintenu dans la chambre de traitement. Le maintien d'un ultravide nécessite l'utilisation de matériaux qui ne sont pas poreux en dessous d'un certain niveau de pression, ce qui peut ne pas être le cas des élastomères.

### Résumé de l'invention

Un objet d'un mode de réalisation est de pallier tout ou partie des inconvénients des fours à recuit thermique rapide existants.

Un autre objet d'un mode de réalisation est que le four à recuit thermique rapide comprend un hublot transparent entre la chambre de traitement et les lampes à haute intensité ou le laser émettant le rayonnement portant l'objet à traiter à haute température.

Un autre objet d'un mode de réalisation est qu'un vide poussé, par exemple à une pression inférieure à 10⁻⁵ Pa puisse être maintenue dans la chambre de traitement.

Un autre objet d'un mode de réalisation est que le montage du four à recuit thermique rapide est simple et à coût réduit.

Un autre objet d'un mode de réalisation est que le coût de fabrication du four à recuit thermique rapide est réduit.

Un mode de réalisation prévoit un four à recuit thermique rapide pour le chauffage d'un objet par un rayonnement électromagnétique, comprenant une première pièce, une deuxième pièce au contact direct de la première pièce, un hublot transparent audit rayonnement, pris en sandwich entre la première pièce et la deuxième pièce, un premier joint entre le hublot et la première pièce, un deuxième joint entre le hublot et la deuxième pièce, et un troisième joint entre la première pièce et la deuxième pièce, le premier joint étant un joint métallique, le deuxième joint étant un joint souple, et le troisième joint étant un joint souple.

Selon un mode de réalisation, le deuxième joint est un joint en élastomère et le troisième joint est un joint en élastomère.

Selon un mode de réalisation, le premier joint est en contact direct avec le hublot et la première pièce et le deuxième joint est en contact direct avec le hublot et la deuxième pièce.

Selon un mode de réalisation, le hublot comprend une première face, une deuxième face opposée à la première face, et un bord périphérique reliant la première face à la deuxième face, et comprenant un interstice entre le bord et la première pièce.

Selon un mode de réalisation, le premier joint est situé entre la périphérie de la première face et la première pièce et le deuxième joint est situé entre la périphérie de la deuxième face et la deuxième pièce.

Selon un mode de réalisation, la première pièce et le hublot délimitent un volume interne, le four comprenant des moyens pour maintenir la pression dans le volume interne à une première pression inférieure à la pression atmosphérique.

Selon un mode de réalisation, le four comprend des moyens pour maintenir la pression dans l'interstice à une deuxième pression inférieure à la pression atmosphérique et supérieure à la première pression.

Selon un mode de réalisation, le premier joint comprend une coque torique à section droite en "C" contenant un ressort à spirales.

Selon un mode de réalisation, le premier joint comprend des lampes à haute intensité en regard du hublot et un support desdites lampes à haute intensité fixé à la deuxième pièce.

Un mode de réalisation prévoit également un procédé de montage du four à recuit thermique rapide tel que défini précédemment, comprenant les étapes suivantes :
- mise en place du premier joint sur la première pièce ;
- mise en place du hublot sur le premier joint ;
- mise en place du troisième joint sur la deuxième pièce ;
- mise en place du deuxième joint sur le hublot ;
- application de la deuxième pièce contre la première pièce ;
- formation d'un vide partiel dans un volume interne délimité par le hublot et la première pièce ; et
- fixation de la deuxième pièce à la première pièce.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et très schématique, d'un exemple de four à recuit thermique rapide comprenant un hublot transparent ;
la figure 2 est une vue en coupe, partielle et schématique, d'un four à recuit thermique illustrant un exemple de fixation du hublot du four ;
la figure 3 est une vue en coupe, partielle et schématique, d'un mode de réalisation d'un four à recuit thermique rapide comprenant un hublot transparent ;
la figure 4 est une vue de détail de la figure 4 ; et
la figure 5 est une vue en coupe d'un joint métallique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, les expressions "environ", "approximativement", "sensiblement", et "de l'ordre de" signifient à 10 % près, de préférence à 5 % près. Sauf précision contraire, les adjectifs numéraux ordinaux, tels que "premier", "deuxième", etc., sont utilisés seulement pour distinguer des éléments entre eux. En particulier, ces adjectifs ne limitent pas les modes de réalisation décrits à un ordre particulier de ces éléments.

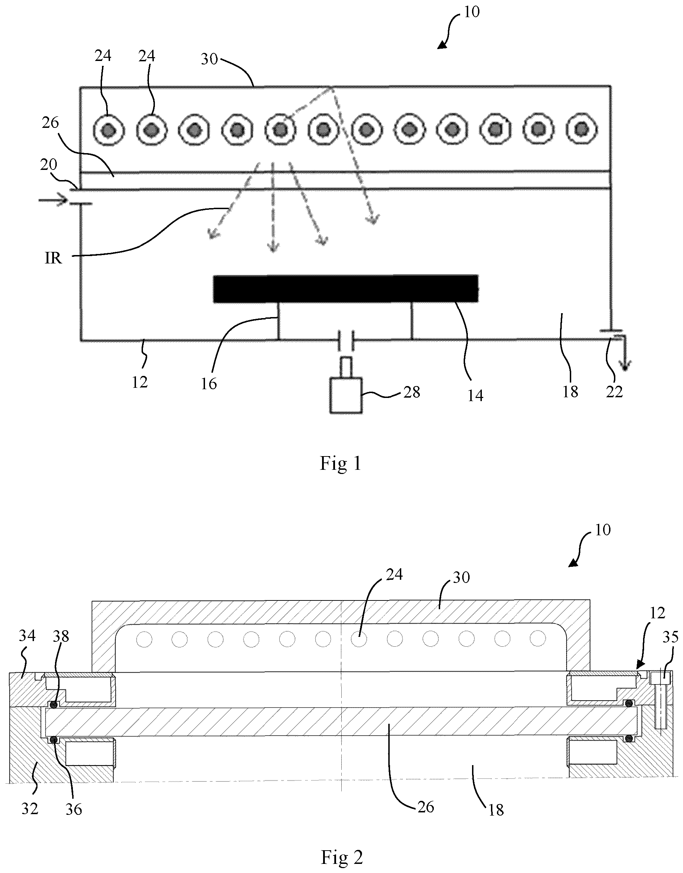

La figure 1 est une vue en coupe, partielle et schématique, d'un exemple de four 10 à recuit thermique rapide.

Le four 10 comprend une enceinte 12, également appelée réacteur, dans laquelle est placé l'objet 14 à traiter qui est disposé sur un reposoir 16. L'objet 14 à traiter est par exemple un substrat de silicium. Un gaz inerte peut être injecté dans le volume interne 18 du réacteur 12 par un système d'injection 20. Le volume interne 18 du réacteur 12 peut être maintenu à basse pression grâce à un système de pompage 22. L'objet 14 à traiter est chauffé par le rayonnement émis par des lampes 24 à haute intensité maintenues par un support 30. Les lampes 24 à haute intensité sont par exemple des lampes infrarouges.

Un hublot 26 ferme le volume interne 18 du réacteur 12 tout en laissant passer le rayonnement IR émis par les lampes 24. Le support 30 est en outre adapté à renvoyer vers le hublot 26 le rayonnement IR émis par les lampes 24. Les parois du réacteur 12 sont refroidies notamment pour éviter de contaminer le substrat 14 et protéger les équipements de commande et/ou de mesure équipant le réacteur 12. La température du substrat 14 peut être contrôlée par un régulateur relié à un pyromètre 28.

La figure 2 est une vue en coupe, partielle et schématique, d'un exemple de fixation du hublot 26 au réacteur 12. Le réacteur 12 est composé d'une première pièce 32 et d'une deuxième pièce 34 fixées l'une à l'autre au moyen de fixations, par exemple des vis, une vis 35 étant représentée à titre d'exemple en figure 2. De préférence, il n'y a pas de soudures entre la première pièce 32 et la deuxième pièce 34. Le hublot 26 est interposé entre la première pièce 32 et la deuxième pièce 34. La première pièce 32 et le hublot 26 délimitent le volume interne 18. la première pièce 32 peut avoir une section droite carrée ou rectangulaire, dans un plan perpendiculaire au plan de coupe de la figure 2.

Le four 10 comprend deux joints souples 36, 38, par exemple des joints élastomères, un joint souple 36 entre le hublot 12 et la première pièce 32 et un joint souple 38 entre le hublot 12 et la deuxième pièce 34. Les joints souples 36 et 38 assurent l'étanchéité du volume interne 18.

Toutefois, pour certaines applications, un ultravide, c'est à dire un vide très poussé, par exemple à une pression inférieure à 10⁻⁵ Pa, de préférence inférieure à 10⁻⁶ Pa, voire inférieure à 10⁻⁷ Pa doit être maintenu dans la volume interne 18. Le maintien d'un ultravide nécessite l'utilisation de matériaux non poreux, ce qui peut ne pas être le cas de l'élastomère composant le joint souple 36 qui assure l'étanchéité entre le volume interne 18 et l'air extérieur ambiant.

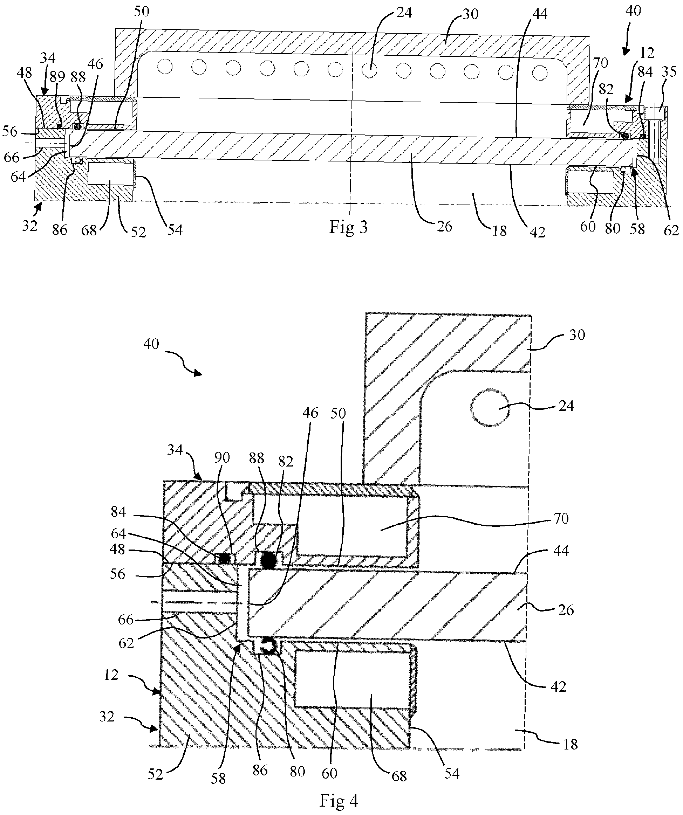

La figure 3 est une vue en coupe, partielle et schématique, d'un mode de réalisation d'un four 40 de recuit rapide et la figure 4 est une vue de détail du four 40.

Le four 40 comprend l'ensemble des éléments du four 10 représenté en figure 2 à la différence que les joints 36 et 38 ne sont pas présents.

Le hublot 26 comprend deux faces principales 42 et 44 reliées par un bord 46. De préférence, les faces principales 42 et 44 sont planes et parallèles. Le bord 46 peut correspondre à une surface cylindrique. En fonctionnement, la face principale 44 est orientée du côté des lampes 24 tandis que la face principale 42 est orientée du côté du volume interne 18. Selon un mode de réalisation, le hublot 26 est en quartz.

La deuxième pièce 34 comprend une face 48 en appui contre la première pièce 32 en fonctionnement et une face 50 en vis-à-vis de la périphérie de la face principale 44 du hublot 26 en fonctionnement. De préférence, la face 48 est plane. De préférence, la face 50 est plane. De préférence, les faces 48 et 50 sont parallèles. De préférence, les faces 48 et 50 sont confondues.

La première pièce 32 comprend une paroi cylindrique 52 comprenant notamment une face interne 54, en regard du volume interne 18 et une face 56 supérieure contre laquelle est en appui la face 48 la deuxième pièce 34 en fonctionnement. De préférence, la face supérieure 56 est plane. La première pièce 32 comprend en outre un enfoncement 58 recevant le hublot 26. L'enfoncement 58 est délimité par deux faces 60 et 62. La face 60 s'étend depuis la face interne 54 et est en vis-à-vis de la périphérie de la face principale 44 du hublot 26 en fonctionnement. De préférence, la face 60 de la première pièce 32 est parallèle à la face 50 de la deuxième pièce 34, lorsque la deuxième pièce 34 est fixée à la première pièce 32.

Les dimensions de la première pièce 32, de la deuxième pièce 34, et du hublot 26 dépendent des applications visées. A titre d'exemple, l'épaisseur du hublot 26 est comprise entre 6 mm et 22 mm. La dimension maximale du hublot 26 mesurée parallèlement à la face principale 42 est comprise entre 150 mm et 440 mm.

Le bord 46 du hublot 26 n'est pas en contact avec la face 62 de l'enfoncement 58 lorsque le hublot 26 est placé dans l'enfoncement 58. Un interstice 64 est présent entre la face 62 de l'enfoncement 58 et le bord 46 du hublot 26, sur la totalité du bord 46. Selon un mode de réalisation, la distance entre le bord 46 et la face 62, mesurée de façon perpendiculaire au bord 46, est comprise entre 2 mm et 6 mm. Le four 40 comprend des moyens pour maintenir un vide partiel dans l'interstice 64. Selon un mode de réalisation, la première pièce 32 comprend au moins un orifice 66 communiquant avec l'interstice 64 à une extrémité et communiquant avec l'extérieur de la première pièce 32 à l'extrémité opposée.

Selon un mode de réalisation, la première pièce 32 comprend au moins une cavité interne 68 dans lesquelles un liquide de refroidissement, par exemple de l'eau, est mis en circulation. Selon un mode de réalisation, la deuxième pièce 34 comprend au moins une cavité interne 70 dans lesquelles un liquide de refroidissement, par exemple de l'eau, est mis en circulation.

La pièce 32 peut être réalisée en acier inoxydable. La pièce 34 peut être réalisée en aluminium, en alliage d'aluminium, en cuivre, en alliage de cuivre, par exemple le laiton, ou en acier inoxydable, et de préférence en acier inoxydable.

Le four 40 comprend un premier joint d'étanchéité 80, correspondant à un joint métallique, entre la face principale 42 du hublot 26 et la face 60 de la première pièce 32, un deuxième joint d'étanchéité 82, correspondant à un joint souple, entre la face principale 44 du hublot 26 et la face 50 de la deuxième pièce 34, et un troisième joint d'étanchéité 84, correspondant à un joint souple, entre la face 66 de la première pièce 32 et la face 48 de la deuxième pièce 34. Les joints souples 82 et 84 sont représentés de façon schématique par des disques noirs sur les figures 3 et 4 et le joint métallique 80 est représenté par un secteur de couronne noir sur les figures 3 et 4.

Selon un mode de réalisation, la première pièce 32 comprend une gorge 86 recevant le joint souple 80. Selon un mode de réalisation, la deuxième pièce 34 comprend une gorge 88 recevant le joint souple 82. Selon un mode de réalisation, la deuxième pièce 34 comprend une gorge 89 recevant le joint souple 84.

Selon un mode de réalisation, le joint 80 ne comprend pas de matériaux susceptibles d'être poreux au contact d'un ultravide. Selon un mode de réalisation, le joint 80 ne comprend pas de polymères. Selon un mode de réalisation, le joint 80 est un joint métallique. Selon un mode de réalisation, les joints souples 82 et 84 sont des joints toriques en élastomères.

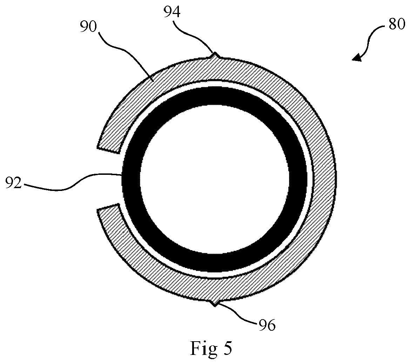

La figure 5 est une vue en coupe d'un mode de réalisation du joint 80. Le joint 80 peut correspond au joint décrit dans le document US5022663. Selon un mode de réalisation, le joint 80 comprend une coque 90 ayant la forme générale d'un tore creux dont la section droite est en forme de "C". La coque 90 contient un ressort 92, par exemple un ressort à spirale, représenté de façon schématique par un anneau noir en figure 5. Le diamètre de la coque 90, avant déformation, peut être compris entre 2 mm et 7 mm. La coque 90 peut comprend deux lèvres 94, 96 sur sa surface externe, la lèvre 94 étant destinée à venir en contact avec la deuxième pièce 34 et la lèvre 96 étant destinée à venir en contact le hublot 26. La coque 90 est métallique, en matériau tendre, par exemple en aluminium ou en cuivre.

En fonctionnement, une pompe à vide, non représentée, peut être raccordée à l'orifice 66 pour maintenir un vide partiel dans l'interstice 64. Selon un mode de réalisation, dans le cas où un vide partiel est réalisé dans le volume interne 18 en fonctionnement, le vide partiel maintenu dans l'interstice 64 est moins poussé que le vide partiel présent dans le volume interne 18. Selon un mode de réalisation, en fonctionnement, dans le cas où un vide partiel est réalisé dans le volume interne 18 en fonctionnement, la pression dans le volume interne 18 correspond, par exemple, à un ultravide et est comprise entre 10⁻⁵ Pa et 10⁻⁸ Pa et la pression dans l'interstice 64 correspond, par exemple, à un vide primaire et est comprise entre 0,1 Pa et 10 Pa.

Selon un mode de réalisation, les joints 80 et 82 sont sensiblement alignés selon une direction perpendiculaire aux faces principales 42 et 44. Ceci permet d'éviter la formation d'un couple dans le hublot 26 en fonctionnement.

Un mode de réalisation d'un procédé de montage du four 40 comprend les étapes suivantes :
- mise en place du joint métallique 80 dans sa rainure 86 ;
- mise en place du hublot 26 sur le joint métallique 80 ;
- mise en place du joint souple 84 dans sa rainure 89 sur la pièce 34 ;
- mise en place du joint souple 82 sur le hublot 26 ;
- mise en place de la pièce 34 contre la pièce 32, en faisant en sorte que le joint souple 82 pénètre dans sa rainure 88 ;
- application d'un léger serrage de la pièce 34 contre la pièce 32 pour contraindre légèrement le joint métallique 80 contre le hublot 26, sans que les pièces 34 et 32 n'entrent en contact ;
- formation d'un vide partiel dans le volume interne 18, ce qui permet au hublot 26 de venir se plaquer parfaitement contre le joint métallique 80 par l'aspiration du vide ;
- dans le cas où le vide partiel aurait du mal être atteint, un serrage supplémentaire de la pièce 34 contre la pièce 32 est envisageable ;
- test d'étanchéité à l'hélium entre le joint métallique 80 et le hublot 26, et serrage supplémentaire de la pièce 34 si nécessaire ;
- une fois l'étanchéité atteinte, serrage au contact de la pièce 34 contre la pièce 32 ; et
- dernier test d'étanchéité à l'hélium par l'orifice 66.

De façon avantageuse, le mode de réalisation d'un procédé de montage du four 40 décrit précédemment est simple. En outre, il peut être mis en oeuvre à coût réduit puisqu'il ne requiert pas d'outillage particulier.

La présence du joint métallique 80 permet d'éviter que des composés de l'air extérieur ambiant ne pénètrent dans le volume interne 18, et ainsi permet d'atteindre le niveau d'ultravide souhaité. La présence du joint souple 82 en élastomère permet d'absorber les surcontraintes entre la première pièce 32 et la deuxième pièce 34 qui pourraient se produire en fonctionnement, et qui, en l'absence du joint souple 82, pourraient se traduire par la formation de surcontraintes dans le hublot 26 pouvant entraîner sa rupture. Le maintien d'un vide partiel dans l'interstice 64, dont l'étanchéité est assurée par le joint souple 84, permet d'éviter que le joint métallique 80 et le joint souple 82 ne soient directement en contact avec l'atmosphère extérieure au four 40, notamment dans le cas où une micro-fuite apparaîtrait entre le joint métallique 80 et le hublot 26 pendant les cycles thermiques, et permettant ainsi au volume interne 18 de maintenir le niveau de pression ultravide recherché.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Four (40) à recuit thermique rapide pour le chauffage d'un objet (14) par un rayonnement électromagnétique (IR), comprenant une première pièce (32), une deuxième pièce (34) au contact direct de la première pièce, un hublot (26) transparent audit rayonnement, pris en sandwich entre la première pièce et la deuxième pièce, un premier joint (80) entre le hublot et la première pièce, un deuxième joint (82) entre le hublot et la deuxième pièce, et un troisième joint (84) entre la première pièce et la deuxième pièce, le premier joint (80) étant un joint métallique, le deuxième joint (82) étant un joint souple, et le troisième joint (84) étant un joint souple.

2. Four selon la revendication 1, dans lequel le deuxième joint (82) est un joint en élastomère et le troisième joint (84) est un joint en élastomère.

3. Four selon la revendication 1 ou 2, dans lequel le premier joint (80) est en contact direct avec le hublot (26) et la première pièce (32) et le deuxième joint (82) est en contact direct avec le hublot (26) et la deuxième pièce (34).

4. Four selon l'une quelconque des revendications 1 à 3, dans lequel le hublot (26) comprend une première face (42), une deuxième face (44) opposée à la première face, et un bord (46) périphérique reliant la première face à la deuxième face, et comprenant un interstice (64) entre le bord et la première pièce (32).

5. Four selon la revendication 4, dans lequel le premier joint (80) est situé entre le la périphérie de la première face (42) et la première pièce (32) et dans lequel le deuxième joint (82) est situé entre la périphérie de la deuxième face (44) et la deuxième pièce (34).

6. Four selon l'une quelconque des revendications 1 à 5, dans lequel la première pièce (32) et le hublot (26) délimitent un volume interne (18), le four comprenant des moyens pour maintenir la pression dans le volume interne à une première pression inférieure à la pression atmosphérique.

7. Four selon les revendications 4 et 6, comprenant des moyens pour maintenir la pression dans l'interstice (64) à une deuxième pression inférieure à la pression atmosphérique et supérieure à la première pression.

8. Four selon l'une quelconque des revendications 1 à 7, dans lequel le premier joint (80) comprend une coque (90) torique à section droite en "C" contenant un ressort (92) à spirales.

9. Four selon l'une quelconque des revendications 1 à 8, comprenant des lampes à haute intensité (24) en regard du hublot (26) et un support (60) desdites lampes à haute intensité fixé à la deuxième pièce (34).

10. Procédé de montage du four (40) à recuit thermique rapide selon l'une quelconque des revendications 1 à 9, comprenant les étapes suivantes :
- mise en place du premier joint (80) sur la première pièce (32) ;
- mise en place du hublot (26) sur le premier joint (80) ;
- mise en place du troisième joint (84) sur la deuxième pièce (34) ;
- mise en place du deuxième joint (82) sur le hublot (26) ;
- application de la deuxième pièce contre la première pièce ;
- formation d'un vide partiel dans un volume interne (18) délimité par le hublot et la première pièce ; et
- fixation de la deuxième pièce à la première pièce.
